# EUROPEAN PATENT APPLICATION

(11) **EP 1 679 745 A2**
(43) Date of publication of application: **12.07.2006**
(21) Application number: 05257385.4
(22) Date of filing: 30.11.2005
(51) Int. Cl.: H01L 23/495, H01L 23/31

(54) **Package for gallium nitride semiconductor devices**

(30) Priority: 10.01.2005 US 32666
(71) Applicant: Velox Semiconductor Corporation, Somerset NJ 08873 (US)
(72) Inventor: Shelton, Bryan S, Bound Brook, NJ 08805 (US); Pabisz, Marek K, Quarkertown, PA 18951 (US); Zhu, TingGang, Somerset, NJ 08873 (US); Gottfried, Mark, Hillsborough, NJ 08844 (US); Liu, Linlin, Hillsborough, NJ 08844 (US); Peres, Boris, Somerset, NJ 08873 (US); Ceruzzi, Alex, Princeton Junction, NJ 08550 (US)
(74) Representative: Beresford, Keith Denis Lewis

(57) **Abstract**

A package for a semiconductor device, in particular a gallium nitride semiconductor structure including a lower semiconductor layer and an upper semiconductor layer disposed over a portion of the lower semiconductor layer. The semiconductor structure includes a plurality of mesas projecting upwardly from the lower layer, each of the mesas including a portion of the upper layer and defining an upper contact surface separated from adjacent mesas by a portion of the lower layer surface. The device further includes a die mounting support, wherein the bottom surface of the die is attached to the top surface of the die mounting support; and a plurality of spaced external conductors extending from the support, at least one of said spaced external conductors having a bond wire post at one end thereof; with a bonding wire extending between the bond wire post and a contact region to the top surface of the plurality of mesas.

## Description

### BACKGROUND OF THE INVENTION

### 1. Field of the Invention

The present invention relates to packaged semiconductor devices, and more particularly to a lead frame and package enclosing a high power gallium nitride semiconductor device.

### 2. The Background Art

Semiconductor devices such as diodes, MOS field effect devices (such as MOSFETs) and the like are commonly formed in a silicon semiconductor wafer, which is cut into die containing an individual device or integrated circuit. The die have metallized pads or other electrodes which are electrically connected to source, gate, and drain regions electrodes in a MOSFET, or the anode and cathode electrode in a diode. These pads are fanned on the upper surface of the die and also serve as bonding areas for wires which are wire bonded and extend from the conductive electrode area of the die to flat connection post areas of a lead frame. The post areas are in turn connected to the exterior lead conductors extending in parallel from the frame and adapted for mounting the device on a printed circuit board. These exterior lead conductors extend through a moulded housing which over moulds the lead frame and die. In order to increase the efficiency of the packaging process, the lead frame will contain a plurality of identical sections, each corresponding to a single packaged semiconductor device which is simultaneously processed to receive separate die and wire bonds and overmoulding. The individual devices are then separated after the moulding process. The package design of the final device may conform or be compliant with well known industry package standards for example, the TO-220, TO-247, DPAK, D²PAK, TO-263 or other package form factors.

The development of gallium nitride semiconductor devices for use in optoelectronic and other applications have presented new packaging requirements for such devices, while manufacturing economics considerations and the desire of customers for pin-compatible components have dictated that such packages still conform to industry accepted packaging formats.

### SUMMARY OF THE INVENTION

### 1. Introduction

The inventors hereof have sought to provide an improved package for a power semiconductor device.

The inventors hereof have sought also to provide a package for a gallium nitride semiconductor device conforming to industry accepted packaging formats.

The inventors hereof have sought also to provide lead frame configuration and semiconductor device structure for improved reliability and low manufacturing cost. It is still another object of the invention to provide an improved method for packaging a semiconductor device using flip-chip technology. Additional objects, advantages, and novel features of the present invention will become apparent to those skilled in the art from this disclosure, including the following detailed description as well as by practice of the invention. While the invention is described below with reference to preferred embodiments, it should be understood that the invention is not limited thereto. Those of ordinary skill in the art having access to the teachings herein will recognize additional applications, modifications and embodiments in other fields, which are within the scope of the invention as disclosed and claimed herein and with respect to which the invention could be of utility.

### 2. Features of the Invention

Briefly, and in general terms, the present invention provides a packaged semiconductor device including a semiconductor die having a top surface including a plurality of mesas projecting upwardly from a lower contact surface, each of the mesas defining an upper contact surface separated from adjacent ones of said plurality of mesas by a portion of said lower contact surface.

The device further includes a die mounting support, wherein the bottom surface of the die is attached to the top surface of the die mounting support, and a housing, which encloses the semiconductor die and the die mounting support.

A plurality of spaced external conductors extends from the housing, and at least one of the external conductors has a bond wire post at one end thereof; a bonding wire extends between bond wire post and a contact region common to the plurality of mesas on the upper contact surface of the semiconductor die.

The method and device of the present invention described herein can thus be utilized in association with devices and/or other semiconductor device structures to improve reliability, control and stability thereof The present invention thus applies to any semiconductor device utilizing mesa structures defining active regions, and in particular III-V semiconductor devices.

The novel features which are considered as characteristic of the invention are set forth in particular in the appended claims. The invention itself, however, both as to its construction and its method of operation, together with additional objects and advantages thereof, best will be understood from the following description of specific embodiments when read in connection with the accompanying drawings.

### BRIEF DESCRIPTION OF THE DRAWING

These and other features and advantages of this invention will be better understood and more fully appreciated by reference to the following detailed description when considered in conjunction with the accompanying drawings, wherein:
Figures 1A, 1B, and 1C are perspective views of a packaged semiconductor device according to the present invention with a variety of different wire bonding configurations;
Figure 2 is a detailed top plan view of the lead frame with a single semiconductor die according to the present invention;
Figure 3 is a detailed top plan view of the lead frame with two semiconductor die according to the present invention;
Figure 4 is an enlarged, detailed top plan view of a gallium nitride semiconductor structure according to the present invention; and
Figure 5 is a fragmentary, cross-sectional detailed view of a semiconductor structure according to the present invention through the A-A plane shown in Figure 4.
Figure 6 is a fragmentary, cross-sectional detailed view of another embodiment of the present invention through the A-A plane shown in Figure 4;
Figure 7 is a top plan view of the semiconductor structure in the embodiment of Figure 6.

### DESCRIPTION OF THE PREFERRRED EMBODIMENT

Details of the present invention will now be described, including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of actual embodiments nor the relative dimensions of the depicted elements, and are not drawn to scale.

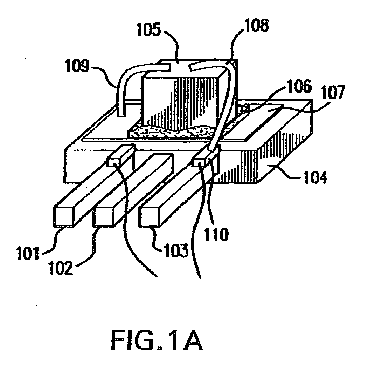

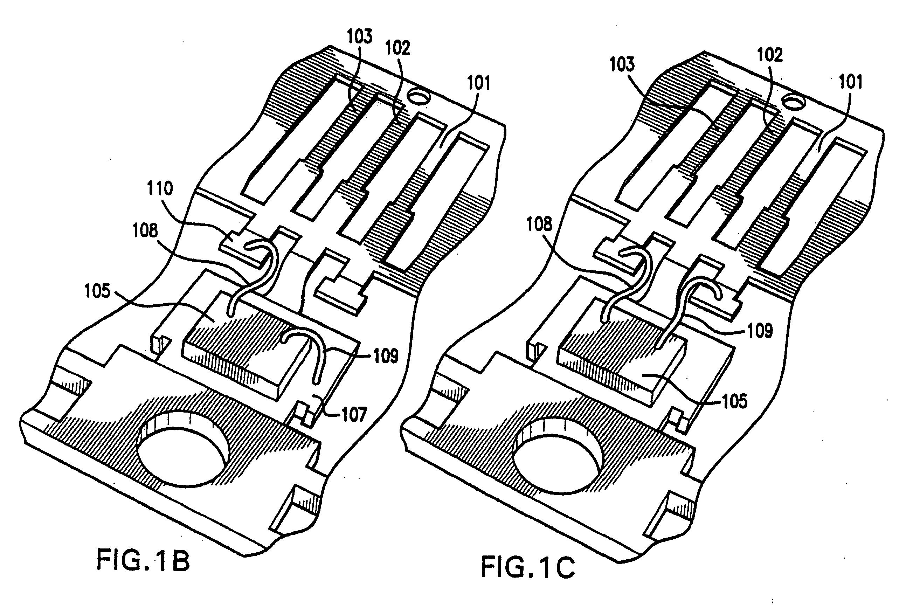

Referring to Figs. 1A, 1B, and 1C there is shown a set of fragmentary, perspective views of a semiconductor die 105 mounted to a lead frame and including features according to the present invention. In particular, in each of the Figures, there are shown leads or electrodes 101, 102, and 103 attached to a support 104 and extending in parallel from a front wall thereof. The leads 101 and 103 may make electrical contact with active regions of the semiconductor die 105, while centre lead 102 may make electrical contact with other mounting elements within the package itself.

The support 104 is preferably composed of a moulded plastic material and encapsulates the lead frame. The semiconductor die 105 is mounted to the support 104 by an epoxy 106. Wire-bonds 108 and 109 are used to make electrical connection between active regions on the top surface of the semiconductor die 105 and wire-bond landing pads 110 on the leads 101 and 103, or a wire-bond landing area or pad 107 on the surface of the support 104.

In particular, Fig. 1A shows a front perspective view of the semiconductor package according to the present invention with a first wire bonding arrangement. In particular, the wire-bond 108 is electrically connected to the lead 103, and wire-bond 109 is electrically connected to pad 107.

Figure 1B is a rear perspective view of the package shown in Fig. 1A showing the wire bonding with one wire-bond 108 connected to lead 103, and the other wire-bond 109 connected to pad 107. The pad 107 is electrically connected to centre lead 102.

Figure 1C is a rear perspective view of a package according to the present invention in a second embodiment of wire bonding with one wire bond 108 connected to a first lead 103 and the other wire bond 109 connected to a second lead 101.

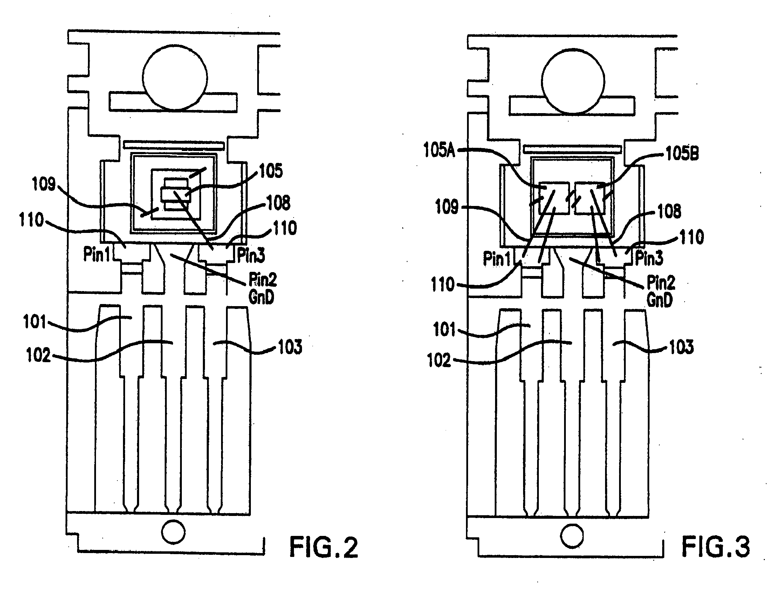

Figures 2 and 3 depict top plan views of the lead frame according to the present invention. More particularly, Fig. 2 illustrates a lead frame with a single die 105, and Fig.3 illustrates a lead frame with two die 105A and IO5B. In both figures, the centre lead 102 is connected to ground.

In the preferred embodiment, the semiconductor device is a high power diode, and the anode and the cathode are attached to two separate bonding electrodes in the packaged die (which are also referred to as leads, of which the packaged lead frame has three). It is also within the scope of the invention that multiple wires go to each of these two leads from the die itself. Therefore, there can be more than one bonding wire from the anode, and more than one bonding wire from the cathode, depending on the die configuration and type of bonding wire used. In addition to the high power diode, other GaN devices can also be incorporated into this package, including GaN field-effect transistors (FETs) or any combination of diodes and FETs to meet the needs of integration and the industry. Wirebond connections may be made to the lead frame as well as from one die to the other to provide the necessary interconnections between the multiple die and the package. Any number of die can be included in the package, assuming that they will fit into the allotted space.

In the preferred embodiment, two 125µm (5 mil) aluminium wires are bonded to the cathode terminal of the die, such wires in turn being connected to the centre lead.

Two 125µm (5 mil) aluminium wires are also connected to the anode terminal of the die, such wires being in turn connected to the rightmost lead.

Some requirements for power devices require that that wirebonds for the cathode and the anode have sufficient gauge (total wire area) to sustain surge currents. In this regard, it becomes necessary to increase the gauge to sustain higher surge currents than the two 5 mil Al wires.

In the case of a standard GaN Schottky diode die, two 5 mil wires would be able to sustain a surge current of 20A - 30A of an 8.2ms half sine wave pulse train (60Hz continuous). For higher surge current capability, 250 µm (10 mil) or 375 µm (15 mil) Al wires must be used. In other embodiments, the wire may be made of gold and be as small as 2 mil, though one may require a total wire thickness from the anode to the lead (sum total of all wires) to be greater than 8 mil (in this case, 4 two mil (2 mil) wires for each of the cathode and anode for a total of 8 wires in the package.

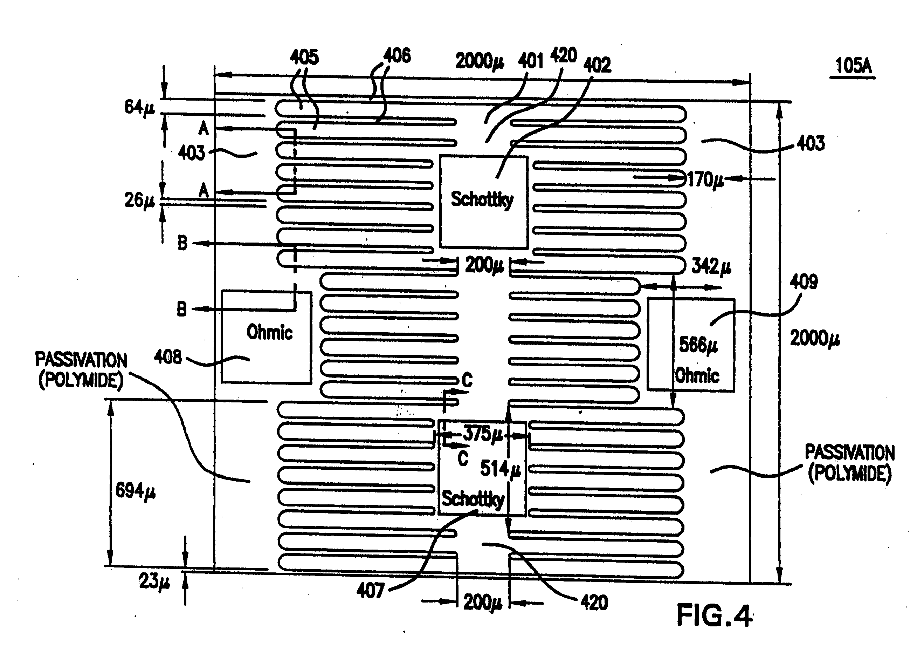

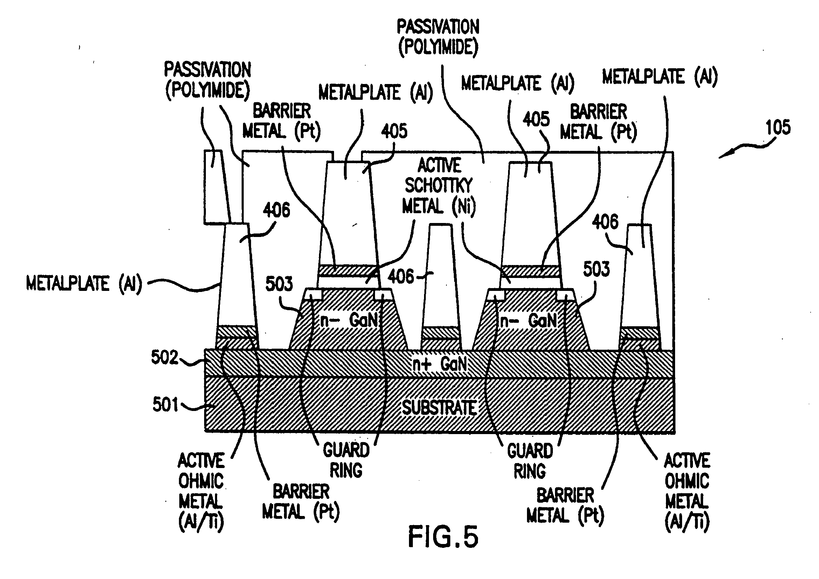

Figure 4 is an enlarged top plan view of a gallium nitride semiconductor device according to the present invention showing the wire-bonding contact regions on the device illustrated by the die 105A or 105B in Fig. 3. As will be seen by examining the fragmentary cross-sectional view of the device illustrated by Fig. 5 as seen through the A-A plane designated in Fig. 4 the device is configured as a mesa structure in which a planar region 401 is at a higher level than planar region 403.

More particularly there are shown two wire-bonding regions 402 and 407 on the surface of the first region 401, representing a contact to the active Schottky metal as shown in Fig. 5, and two wire-bonding regions 408 and 409> on the second or lower region 403, representing a contact to active ohmic metal

Figure 5 is a fragmentary, cross-sectional detailed view of a semiconductor structure according to the present invention through the A-A plane shown in Figure 4.

In particular, there is shown a sapphire substrate 501, a highly doped (n⁺) layer 502 of GaN and a lengthy doped (n⁻) layer 503 deposited over portions of the layer 502. As more particularly shown in Fig. 4, the layer 503 is laid out in "fingers" 405 extending in opposite directions from a centre-line bisecting the die 105A. A metal such as nickel is deposited on the n⁻ GaN layer 503 to form a Schottky junction, so that the resulting device is a Schottky diode.

A barrier metal such as platinum is deposited over the active Schottky metal, and a metal plate layer such as aluminium is deposited over the barrier metal. The metal plate layers form the region 401 in Fig. 4 which represents an electrical contact to one terminal of the diode more particularly represented as two substantially square bonding pads or areas 402 and 407 each about 375 microns in length, which are situated in a central region of the die 105A.

Similarly, an active ohmic contact is made to the n⁺ GaN layer with an Al/Ti, which forms relatively narrow regions 406 between the larger fingers 405. A barrier metal such as platinum is deposited over the ohmic contact layer, and in turn a metal plate layer such as aluminium deposited over the barrier metal layer. The metal plate layer form the region 403 in Fig. 4 which represents an electrical contact to the second terminal of the diode, more particularly represented by two substantially square bonding pads or areas 408 and 409 each about 375 µm in side length, which are situated on opposite sides of the chip 105A or the peripheral side.

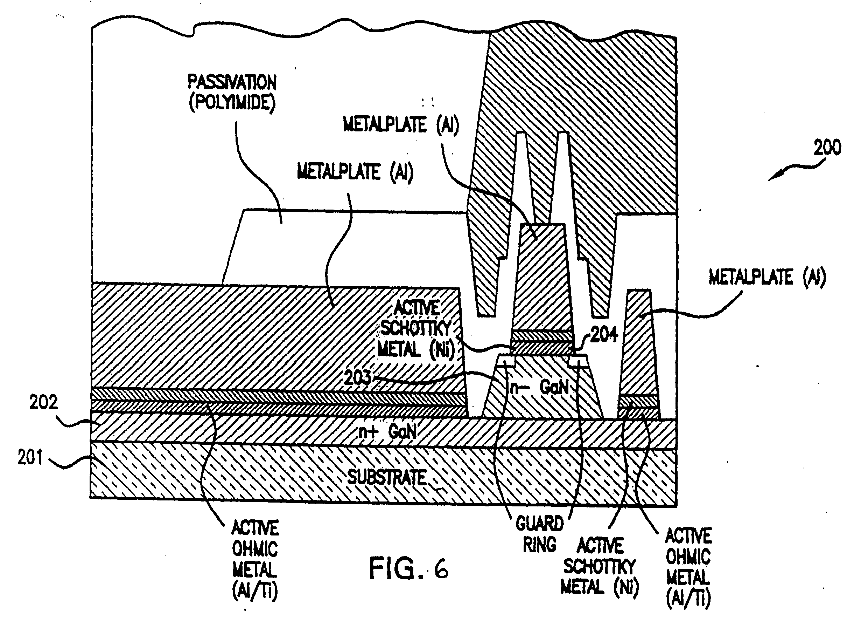

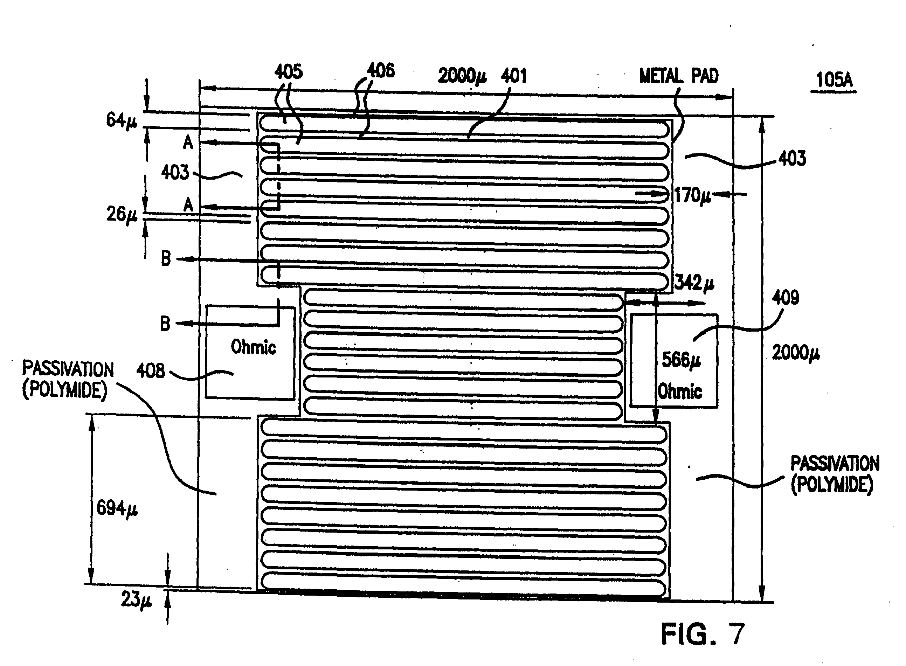

Figure 6 is a fragmentary, cross-sectional detailed view of another embodiment of the present invention through the A-A plane shown in Figure 4. More particularly, a first dielectric layer 601 covers the active ohmic layers in a first portion of the die, and an anode bond metal layer is deposited making electrical contact with each of the "fingers" 405, and forming an anode bond pad region on one side of the die. Similarly, a second dielectric layer is deposited over the anode bond metal layer, and having vias allowing a cathode bond metal layer to be deposited making electrical contact with the ohmic contacts. Such cathode metal layer forms a bond pad region on another side of the die, such as illustrated in Figure 7.

Theoretically, for lateral GaN Schottky diodes, the lowest forward operating voltage for a given current density is obtained by using a narrow finger shaped Schottky contact area, such as shown in Figure 4, which optimizes lateral current spreading in the low doped n⁻ GaN layer. In addition the ohmic metal traces are also optimized to reduce the metal spreading resistance. However, the finger shaped Schottky mesa area requires long Schottky and ohmic metal traces for anode and cathode interconnections, leading to larger contact metal spreading resistance, as opposed to a large single metal contact pad. As a result, the forward operating series resistance increases and causes non-uniformly distributed current. Although using multiple wire-bonds uniformly distributed in both Schottky and ohmic metal traces may reduce the metal spreading resistance, the cost of packaging also increases. In addition to the current spreading non-uniformity, the thermal resistance of a GaN/Sapphire epitaxial layer Schottky diode is much higher than a silicon or SiC diode due to the poor thermal conductivity of the sapphire substrate. Combined with the fact that no efficient thermal conductor is used directly above the active areas, the resulting increase of operating junction temperature is detrimental to device reliability, as well as limits the operating range of the device.

Flip chip process can significantly reduce the thermal resistance by directly mounting the epitaxial side of the die to a heat sink or mounting element. A common way to exercise flip chipping is to attach the die to a submount first then attach the submount to the package lead frame. The additional submount and die attach, however, will add to the total packaging cost.

One embodiment of the present invention is to fabricate appropriate electrodes on the surface of the chip, and then perform die attaching via flip-chip method directly onto the lead frame.

The processing or device fabrication sequence of steps according to the present invention may be described as follows:
1. Deposit a metal layer on an epitaxial structure composed of a sapphire substrate, a highly doped (n+) layer of GaN, and lightly doped (n-) layer of GaN (intrinsic GaN may be substituted for n- GaN). The metal and the n- GaN layer should form Schottky contact. This Schottky metal also serves as the anode metal of a Schottky diode device.
2. Form mesas can be a single electrode or multiple electrically isolated islands. (The sequence of Steps 1 and 2 can be interchanged, as an alternative).
3. Deposit n type ohmic metal on the remaining n⁺ layer. The n type ohmic metal serves as the cathode contact for the Schottky diode device.
4. Deposit a dielectric layer with openings on top of a substantial portion of the anode metal layer and selected portion, of the cathode metal layer.
   The dielectric layer functions to isolate the anode from the cathode contact regions.
5. Deposit a single electrode metal layer that:
   - Provides a common connection to the anode mesa structures through the anode openings described in process step 4.
   - Builds upon the cathode metal through the said cathode opening described in step 4.
   - It is noted that this Step 5 may be broken into two distinct metal deposition steps: first coating the anode, and second coating the cathode.
6. Deposit a dielectric layer with two openings exposing part or entire surface of the cathode and anode metals. The dielectric layer must isolate the anode from the cathode regions.
7. Deposit interconnecting metal traces for both cathode and anode interconnecting to the next stage packaging through the openings described in step 6.
8. (Optional) A portion of the bond pads may be coated with a non-conducting layer of dielectric to prevent arcing at high voltages (not shown).
9. Attach chip after completion of either process step 6 or 7 to a lead frame by using conductive epoxy or by soldering.

It will be understood that each of the process steps or component elements described above, or two or more together, also may find a useful application in other types of constructions differing from the types described above.

While the invention has been illustrated and described as a packaged semiconductor device for a gallium nitride structure, it is not intended to be limited to the details shown, since various modifications and structural changes may be made without departing anyway from the scope of the present invention.

Without further analysis the foregoing will so fully reveal the gist of the present invention that others can, by applying current knowledge, readily adapt it for various applications without omitting features that, from the standpoint of prior art, fairly constitute essential characteristics of the generic or specific aspects of this invention and, therefore, such adaptations should and are intended to be comprehended within the scope of the following claims.

## Claims

1. A semiconductor device comprising:
a semiconductor die having a top surface including a lower semiconductor layer and an upper semiconductor layer disposed over a portion of said lower semiconductor layer, said lower semiconductor layer and said upper semiconductor layer being of the same conductivity type, said lower semiconductor layer being more highly doped than said upper semiconductor layer, said semiconductor die including a plurality of mesas projecting upwardly from said lower contact surface, each of said plurality of mesas including a portion of said upper layer and defining an upper contact surface separated from adjacent ones of said plurality of mesas by a portion of said lower contact surface; and a bottom surface opposite to said top surface;
a die mounting support, wherein the bottom surface of said die is attached to the top surface of said die mounting support;
a housing enclosing said semiconductor die and die mounting support;
a plurality of spaced external conductors extending from said housing, at least one of said spaced external conductors having a bond wire post at one end thereof; and
a first bonding wire extending between one of said bond wire posts and a first contact region common to said plurality of mesas.

2. A device as defined in claim 1, wherein said upper and lower semiconductor layers are composed of gallium nitride.

3. A device as defined in claim 1, further comprising a second bonding wire extending between said one bond wire post and a second contact region on the upper contact surface of the semiconductor die and common to said plurality of mesas.

4. A device as defined in claim 3, wherein said first and second bonding wires have a 25 µm (5 mil) thickness.

5. A device as defined in claim 3, wherein said contact regions are substantially square regions with a side dimension of about 375 µm.

6. A device as defined in claim 1, further comprising a second bonding wire extending between another one of said wire posts and a first contact region on the lower contact surface of the semiconductor die.

7. A device as defined in claim 1, wherein said semiconductor die is a diode capable of operating at a forward voltage of 8 amperes.

8. A device as defined in claim 6, further comprising a third bonding wire extending between said another one of said bond wire posts and a second contact region on the lower contact surface of the semiconductor die.

9. A device as defined in claim 1, wherein said device is a Schottky diode.

10. A device as defined in claim 1, wherein said mesas form a sequence of elongated parallel fingers extending in opposite directions away from a central region in the middle of the semiconductor die.

11. A semiconductor device comprising:
a semiconductor die having a top surface including a lower semiconductor layer and an upper semiconductor layer disposed over a portion of said lower semiconductor layer, said lower semiconductor layer and said upper semiconductor layer being of the same conductivity type, said lower semiconductor layer being more highly doped than said upper semiconductor layer;
a first metal layer disposed over the upper layer and forming a Schottky junction on each of a plurality of mesas projecting upwardly from said lower contact surface, each of said plurality of mesas including a portion of said upper layer and defining an upper contact surface separated from adjacent ones of said plurality of mesas by a portion of said lower contact surface, a second metal layer disposed over said first metal layer and making electrical contact with each of the Schottky devices on said mesas and forms a first electrode bonding surface;
a third metal layer disposed over portions of said lower semiconductor layer and making ohmic contact therewith; and
a fourth metal layer disposed over said third metal layer and forming a second electrode bonding surface.

12. A device as defined in claim 11, further comprising
a die mounting support having first and second bonding electrodes, wherein the top surface of said die is attached to the top surface of said die mounting support so that the first and second electrode bonding surfaces of the die make electrical connection to the first and second bonding electrodes respectively.

13. A device as defined in claim 12, wherein said die is directly attached to the die mounting support by solder or thermally conductive epoxy.

14. A device as defined in claim 11, wherein said second and said fourth metal layers are solderable metal layers..

15. A device as defined in claim 11, wherein said second and said fourth layers form substantially rectangular discrete bonding areas on the top surface of the die, each area separated from the other area by a region of dielectric material.
